Europäisches Patentamt

(19) European Patent Office

Office européen des brevets

(11) Publication number: **0 113 954**
**B1**

## (12) EUROPEAN PATENT SPECIFICATION

(45) Date of publication of patent specification: **27.05.87**

(21) Application number: **83306543.6**

(22) Date of filing: **27.10.83**

(51) Int. Cl.⁴: **C 30 B 25/18,** C 30 B 19/12, C 30 B 23/02

(54) A substrate for manufacturing single crystal thin films.

(30) Priority: **17.11.82 JP 202298/82**

(43) Date of publication of application:
**25.07.84 Bulletin 84/30**

(45) Publication of the grant of the patent:
**27.05.87 Bulletin 87/22**

(84) Designated Contracting States:
**DE FR GB NL**

(56) References cited:
**WO-A-81/02948**
**GB-A-1 601 206**

**INTERNATIONAL ELECTRON DEVICES
MEETING 1979, Washington, D.C., 3rd-5th
December 1979, pages 210-212, IEEE, New
York, USA M.W. GEIS et al.: "Crystalline silicon
on insulators by graphoepitaxy"
JAPANESE JOURNAL OF APPLIED PHYSICS,
vol. 20, no. 12, December 1981, pages L905-
L908, Tokyo, JP. H. MORI: "2-D Grating
graphoepitaxy of silicon films from silicon-gold
supersaturated solution"**

(73) Proprietor: **Hamakawa, Yoshihiro
3-17-4, Minami-Hanayashiki
Kawanishi Hyogo (JP)**

(72) Inventor: **Hamakawa, Yoshihiro
17-4, Minamihanayashiki 3-chome
Kawanishi-shi Hyogo-ken (JP)**
Inventor: **Takakura, Hideyuki
3-12, Hata 2-chome
Ikeda-shi Osaka (JP)**

(74) Representative: **Myerscough, Philip Boyd et al
J.A.Kemp & Co. 14, South Square Gray's Inn
London, WC1R 5EU (GB)**

**Description**

The present invention relates to a process for preparing a substrate for use in manufacturing single crystal thin films.

Recently, there has been an increasing demand for large area thin films and single crystals in the form of a thin plate for use in solar cells, imaging sensors, ultra-large scale integrated circuits and electroluminescence displays. In the semi-conductors and dielectric materials which are currently employed as electronic circuit elements and display devices, a large single crystal is grown from a seed crystal so as to be formed into a thin-plate configuration by sawing for practical uses. Concerning crystalline silicon which has been widely employed as an electronic circuit element, functional devices such as transistors or diodes are fabricated in the portion only 10 to 20 μm deep from the surface of the substrate. However, the actual thickness of the substrate is in the range of 300 to 400 μm for convenience in the processing steps. This means that more than 95% of the thickness of the expensive single crystal substrate is used merely for supporting purposes, and less than 5% of the thickness is allotted for the functional devices.

International Electron Devices Meeting, 3—5 December, 1979, Technical Digest pages 210—212 discloses the manufacture of materials with single crystal characteristics by depositing an amorphous silicon film over surface relief structures, such as gratings etched into amorphous fused silica substrates, and then crystallising the film using an argon laser.

The present invention provides a process for preparing a substrate for use in manufacturing single crystal thin films, which substrates are capable of growing single crystal thin films of large areas at high purity with the thickness necessary for functional devices and for use in various extremely large and important fields of electronics.

According to the invention there is provided a process for preparing a substrate for use in manufacturing single crystal thin films which comprises pressing a material in a softened state against a single crystal cleavage plane comprising a plurality of quadrangular pyramidal projections having a sharp apex, each face of said projections having {111} plane symmetry of a cubic lattice and thereafter hardening the material to form a substrate as a replica pattern of the single crystal cleavage plane comprising inverted pyramidal recesses corresponding with said projections. The invention also provides a modification of this process wherein said substrate is prepared as a replica pattern of the single crystal cleavage plane, by vapor depositing a metal onto a single crystal cleavage plane comprising a plurality of quadrangular pyramidal projections having a sharp apex, each face of said projections having {111} plane symmetry of a cubic lattice to form a metal layer thereon, plating said metal layer to form a plated layer as a replica pattern of the single crystal cleavage plane of said metal layer, and removing said intermediate metal layer.

This invention will now be illustrated in more detail by reference to the accompanying drawings in which:

Fig. 1 is a perspective view of an original plate 1 having a surface comprising a single crystal cleavage plane for use in manufacturing a substrate 2 according to one preferred embodiment of the invention,

Fig. 2 is a perspective view of a substrate 2 prepared according to one embodiment of the invention,

Fig. 3 is a schematic diagram showing one recess of the substrate 2 shown in Fig. 2,

Fig. 4 is a sectional view illustrating a manufacturing process according to another embodiment of the invention,

Fig. 5 is a sectional view illustrating a manufacturing process according to a further embodiment of the invention, and

Fig. 6 is a side elevational view showing a manufacturing process according to still another embodiment of the invention.

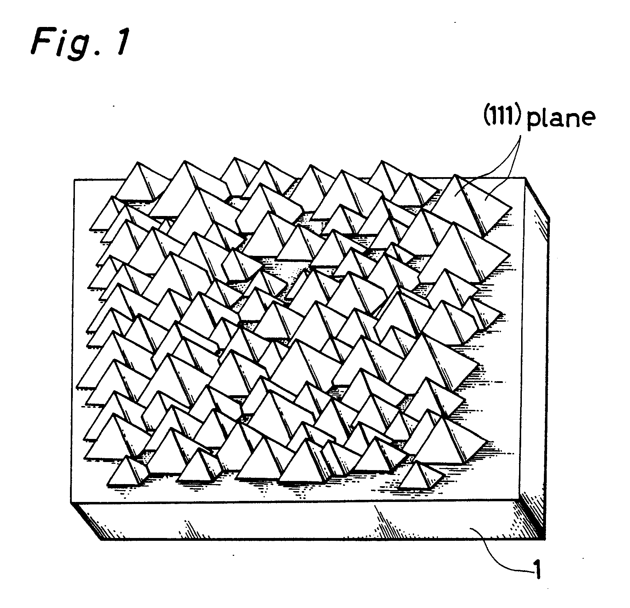

Referring now to the drawings, one preferred embodiment of the present invention will be described hereinbelow. In order to realize a substrate for manufacturing single crystal thin films according to the present invention, a silicon single crystal wafer having a {100} surface is prepared by the conventional method. Subsequently, the wafer having the {100} surface is subjected to anisotropic etching, and an original plate 1 as shown in Fig. 1 is produced. Each face of the quadrangular pyramidal projections on the original plate 1 has {111} plane symmetry, this being the cleavage plane of the slowest etching rate. The etching solution for effecting such anisotropic etching may be, for example, hydrazine hydrate, NaOH, KOH or a mixture of ethylenediamine and pyrocatechol.

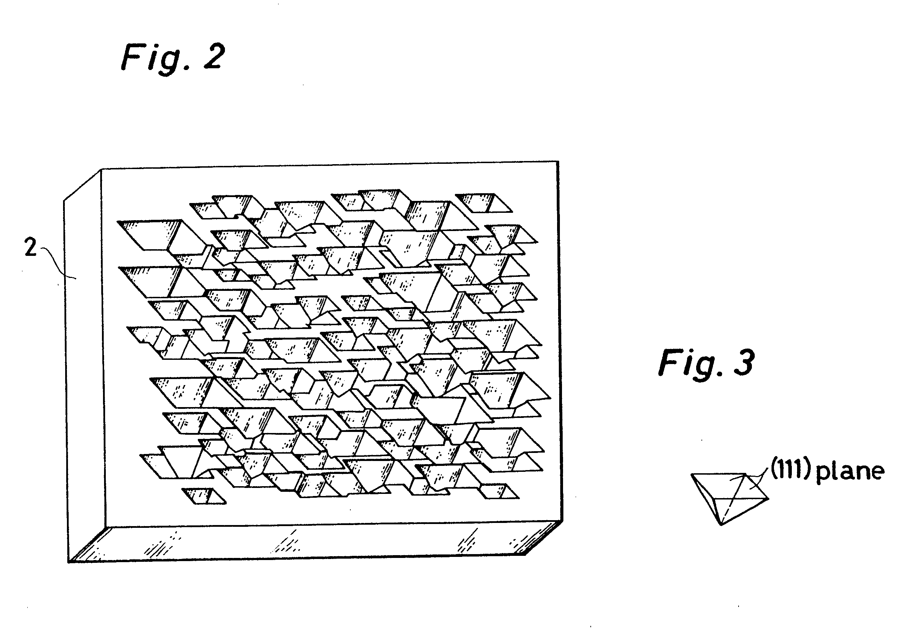

By pressing a material in a softened state onto a surface of the original plate 1 shown in Fig. 1 and then hardening the material a substrate as shown in Fig. 2 is obtained. A substrate having a large area may be obtained by arranging a large number of such substrates 2 side-by-side to obtain a required area.

Reference is made to a schematic diagram of Fig. 3 showing a recess of the substrate 2 of Fig. 2. Each of the four faces constituting such a quadrangular recess have the {111} plane symmetry of a cubic lattice, and the apex thereof is sharp.

Through crystallization of semi-conductors and dielectric materials on the substrate 2 shown in Fig. 2 to the required thickness, a single crystal thin film may be obtained. For the deposition of a crystalline substance on the substrate 2, there may be employed the vapor growth or vapor phase epitaxy method such as vapor deposition, chemical vapor deposition (CVD), molecular beam epitaxy and atomic beam epitaxy, or the so-called liquid growth or liquid phase epitaxy such as molten liquid growth method or solution growth method. The requirements for a material of the substrate 2 are such that:

(a) the material should withstand high temperatures during formation of a single crystal on the substrate 2, for example at 500 to 1000°C.

(b) the material should not deform during hardening, and should also have a sufficient strength for handling as the substrate 2

(c) the material should be capable of correctly transferring the shape of the pyramidal projections of the crystal surface to the replica, without any strain or distortion, and

(d) the material should be inexpensive.

For the materials of the substrate 2 as described above, ceramics or graphite, for example, are suitable. For the ceramics, there may be employed those mainly composed, for example, of alumina ($Al_2O_3$), boron nitride (BN), SiC, or metal. Moreover, for the material of such substrate 2, glass may be adopted.

A substrate 2 made of metal may be produced in the manner as described hereinbelow.

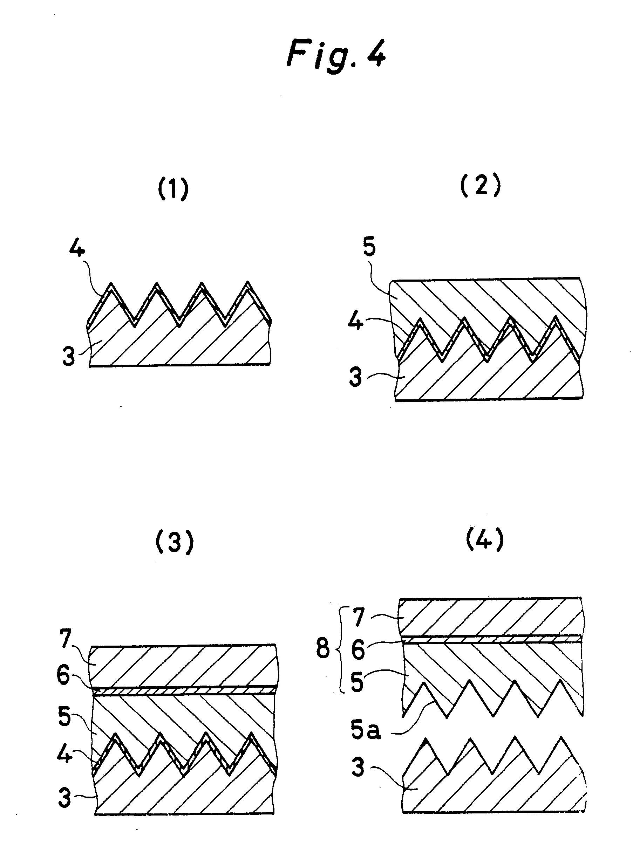

Referring to Fig. 4 (1), metal is vapor-deposited on an original plate 3 to form a vapor deposition layer 4. This vapor deposition layer 4 is, for example, of tin or zinc. Subsequently, plating is effected with the vapor deposition layer 4 as an electrode as shown in Fig. 4(2) to form a plated layer 5. This plated layer 5 may, for example, be of nickel. Then, as shown in Fig. 4(3), the plated layer 5 is brazed onto a base 7 by a brazing metal 6. For the brazing metal 6, metals such as gold or silver, having high melting points and capable of withstanding the high temperatures during subsequent single crystal formation should be employed.

The base 7 may, for example, be of stainless steel. In the manner as described above, the surface relief of {111} plane symmetry formed on the surface of the original plate 3 is transferred to the vapor deposition layer 4 and the plated layer 5. Then, the semi-finished product shown in Fig. 4(3) is immersed in a solution for selectively dissolving the vapor deposition layer 4, and a substrate 8 including the plated layer 5 having a surface 5a, brazing metal 6 and base 7 is obtained as shown in Fig. 4(4). For the solution, for example, hydrochloric acid may be employed when the vapor deposition layer 4 is of tin.

As metals which may be used in place of ceramics, graphite or glass, there may be used, for example, stainless steel, molybdenum, tungsten or platinum.

As described above, the surface relief of {111} plane symmetry on the surface of the original plate 3 is transferred onto the surface 5a of the plated layer 5 for the replica, and through crystallization of semi-conductors and dielectric materials on the surface 5a of the plated layer 5, a single crystal thin film can be obtained.

The vapor deposition layer 4 may be of gold, or such vapor deposition layer 4 may be replaced by a plated layer 5 formed on the original plate 3. The original plate 3 has a different thermal expansion coefficient from the substrate 8, and it may be so arranged that the substrate 8 is detached from the original plate 3 through utilization of such a difference in the thermal expansion coefficients.

When a large number of substrates 2 and 8 are manufactured with the use of the original plates 1 and 3, the original plates are gradually subject to deformation, destruction and abrasion. To produce fresh original plates 1 and 3 is troublesome, with a consequent reduction in the productivity of substrates 2 and 8.

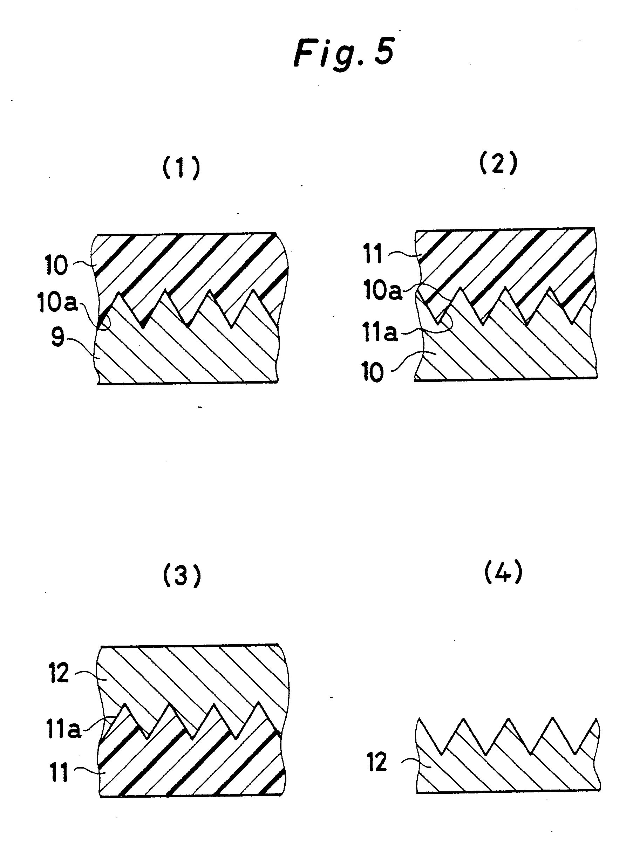

In order to overcome such problems, productivity may be improved in the manner described below with reference to Fig. 5.

Referring to Fig. 5(1), a pyramidal surface similar to the original plate 1 is formed on the surface of the original plate 9 which is of silicon single crystal. By pressing a thermosetting resin, for example an epoxy resin, in a softened state against the surface of the original plate 9 and then hardening the resin, a first substrate 10 is produced. The surface 10a of this first substrate 10 has the {111} plane symmetry of a cubic lattice. Next, as shown in Fig. 5(2), a thermosetting resin in the softened state is pressed against the surface 10a of the first substrate 10 and is then hardened to produce a second substrate 11 which has a surface 11a having the same configuration as that of the original plate 9. In the next step, as shown in Fig. 5(3), a material in a softened state is pressed against the surface 11a of the second substrate 11 and is then hardened to provide a third substrate 12 as shown in Fig. 5(4). The third substrate 12 may be, for example, of ceramics, graphite or glass, as described earlier, or may be manufactured in such a manner that, through vapor deposition or plating on the surface of the second substrate 11, the second substrate 11 is thereafter removed by heating or by chemicals. In this way the third substrate 12, on which single crystal films are formed, may be produced in large number from the second substrate 11, and when this commonly used second substrate 11 is worn out, abraded, deformed or broken, it may be reproduced in large number from the first substrate 10. Therefore, only when the first substrate 10 becomes unusable, such first substrate 10 may be produced from the original plate 9. In this manner, the number of productions of the first substrate 10 from the original plate 9 may be reduced, and accordingly, the number of productions of the original plate 9 may also be decreased, with a consequent improvement in productivity.

According to the present invention, it may be so arranged that the second substrate 11 is produced by materials such as ceramics, graphite, glass and metals, instead of a thermosetting resin so as to form a single crystal on such second substrate 11.

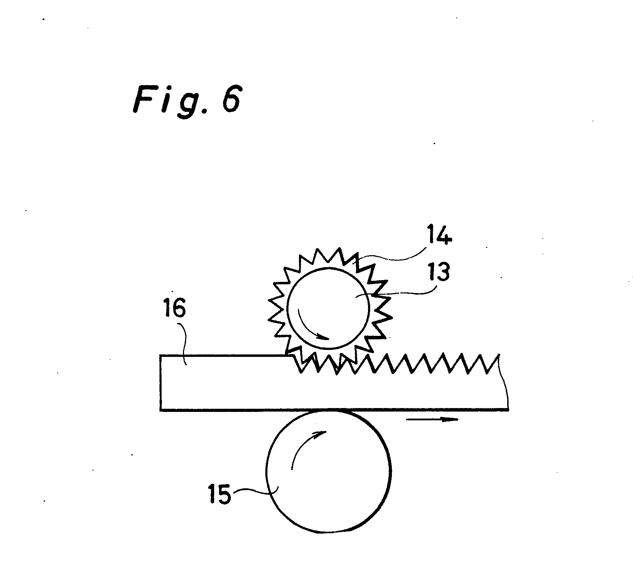

Instead of forming a large area single crystal thin film by arranging the substrates 2, 8, 10, 11 and 12 (collectively represented by a reference numeral 14 hereinafter) thus obtained adjacent to each other on one flat plane, such substrates 14 may be pasted for fixing on a surface of a large straight cylindrical drum 13 as shown in Fig. 6, while the material 16 in the softened state is inserted between the drums 13 and 15 during rotation thereof whereby the surface relief having {111} plane symmetry formed on the surface of the substrate 14 is transferred onto the material 16, which may be used as a substrate.

The substrates 14 may be replaced by a silicon single crystal. The pyramidal structure of the silicon single crystal having the {111} plane, is about 1 μm, for example, in its height, and therefore, in the external shape of the substrate 14 applied on the drum 13, the deformation of the {111} plane may be suppressed to such a range as it can be neglected by providing a drum having a diameter of, for example, 1 m.

In the foregoing embodiments, although silicon is employed for the original plates 1 and 9, this may be replaced by other crystals, for example, rock crystals.

Since the substrate 8 shown in Fig. 4 and the third substrate 12 shown in Fig. 5 are replicas of the pyramidal structure of the original plates 1, 3 and 9, there are recesses constituted by the faces having {111} plane symmetry of a cubic lattice. Since the bottom portions of the recesses of such substrates 2, 8 and 12 are sharp, there is a superior effect that the crystals readily grow as compared with the original plates 1, 3 and 9. Meanwhile, if these substrates 2, 8, 10, 11 and 12 are realized by materials having superior electrical insulation, it becomes possible to improve the electrical insulation among the functional elements of integrated circuits employing dielectric crystals formed on these substrates 2, 8, 10, 11 and 12 for a further facilitation of integration at higher density. On the other hand, in the case where materials superior in heat conductivity are employed for the materials of such substrates 2, 8, 10, 11 and 12, it is possible to favorably effect heat dissipation of integrated circuits employing semi-conductors formed thereon. Moreover, if these substrates 2, 8, 10, 11 and 12 are made of metal, they may be used as electrodes as they are, with a consequent elimination of contact resistance. Furthermore, when inexpensive materials are used for these substrates 2, 8, 10, 11 and 12, with the single crystal being formed by a required thickness, extremely cheap integrated circuits, for example, may be realized. The crystals onto the substrates thus formed by the replica may be, for example, semi-conductors such as GaAs or InSb, and dielectric materials, for example, ferroelectric materials such as $PbTiO_3$ or PLZT.

In still another embodiment according to the present invention, a first substrate which is the replica of the single crystal cleavage plane is prepared using a material such as a synthetic resin, and a second substrate which is the replica of the first substrate is formed on the surface of the first substrate using a material such as a metal through vapor deposition or plating, and thereafter, the first substrate is dissolved using a solvent.

## Claims

1. A process for preparing a substrate for use in manufacturing single crystal thin films which comprises pressing a material in a softened state against a single crystal cleavage plane (1) comprising a plurality of quadrangular pyramidal projections having a sharp apex, each face of said projections having {111} plane symmetry of a cubic lattice and thereafter hardening the material to form a substrate as a replica pattern (2) of the single crystal cleavage plane comprising inverted pyramidal recesses corresponding with said projections.

2. A modification of the process claimed in claim 1, wherein said substrate is prepared as a replica pattern of the single crystal cleavage plane, by vapor depositing a metal onto a single crystal cleavage plane (3) comprising a plurality of quadrangular pyramidal projections having a sharp apex, each face of said projections having {111} plane symmetry of a cubic lattice to formula metal layer (4) thereon, plating said metal layer (4) to form a plated layer (5) as a replica pattern of the single crystal cleavage plane, on said metal layer (4), and removing said intermediate metal layer (4).

3. A process according to claim 1, wherein said substrate is prepared by pressing a first thermosetting resin in a softened state against a single crystal cleavage plane (9) comprising a plurality of quadrangular pyramidal projections having a sharp apex, each face of said projections having {111} plane symmetry of a cubic lattice to form a first substrate (10) of said first resin having, as a replica pattern of said single crystal cleavage plane (9), a first surface (10a) of {111} plane symmetry of a cubic lattice, hardening said first substrate (10), pressing a second thermosetting resin in a softened state against said first surface (10a) of said hardened first substrate (10) to form a second substrate (11) of said second resin having a second surface (11a) of the same configuration as said single crystal cleavage plane, hardening said second substrate (11), pressing a third material in a softened state against said second surface (11a) of said hardened second substrate (11) to form a third substrate (12) of said third material having, as a replica pattern of said second surface, a third surface of {111} plane symmetry of a cubic lattice, and hardening said third substrate (12).

4. A process for forming a substrate for use in manufacturing single crystal thin films wherein a substrate (14) prepared by a process as claimed in claim 1, 2 or 3 is fixed to the outside surface of a cylindrical drum (13), a material (16) in a softened state is inserted between the cylindrical drum (13) and an auxiliary drum (15) as they rotate whereby the replica pattern is transferred from the substrate (14) onto the surface of said material (16), and thereafter hardening said material (16) for use as a substrate.

5. Use of a substrate prepared in accordance with any one of the preceding claims in the manufacture of single crystal thin films.

## Patentansprüche

1. Verfahren zur Fertigung eines Substrats zur Verwendung bei der Herstellung von einkristallinen Dünnschichten, gekennzeichnet durch Pressen eines Materials in einem erweichten Zustand gegen eine Einkristall-Spaltebene (1), die eine Vielzahl von vierseitigen pyramidenförmigen Vorsprüngen mit einem spitzen Scheitelpunkt umfaßt, wobei jede Fläche der Vorsprünge eine {111}—Flächensymmetrie eines kubischen Gitters hat, und anschließendes Härten des Materials, um ein Substrat als ein Nachbildungsmodell (2) der Einkristall-Spaltebene mit umgekehrten pyramidenförmigen, den Vorsprüngen entsprechenden Vertiefungen auszubilden.

2. Abwandlung des in Anspruch 1 beanspruchten Verfahrens, dadurch gekennzeichnet, daß das Substrat als ein Nachbildungsmodell der Einkristall-Spaltebene durch Aufdampfen eines Metalls auf eine Einkristall-Spaltebene (3), die eine Vielzahl von vierseitigen pyramidenförmigen Vorsprüngen mit einem spitzen Scheitelpunkt umfaßt, wobei jede Fläche der Vorsprünge eine {111}—Flächensymmetrie eines kubischen Gitters hat, um daran eine Metallschicht (4) auszubilden, gefertigt wird, daß die Metallschicht (4) plattiert wird, um eine plattierte Schicht (5) als ein Nachbildungsmodell der Einkristall-Spaltbene an der Metallschicht (4) auszubilden, und daß die zwischenliegende Metallschicht (4) entfernt wird.

3. Verfahren nach Anspruch 1, dadurch gekennzeichnet, daß das Substrat durch Pressen eines ersten härtbaren Harzes in einem erweichten Zustand gegen eine Einkristall-Spaltebene (9), die eine Vielzahl von vierseitigen pyramidenförmigen Vorsprüngen mit einem spitzen Scheitelpunkt umfaßt, wobei jede Fläche der Vorsprünge eine {111}—Flächensymmetrie eines kubischen Gitters hat, um ein erstes Substrat (10) des ersten Harzes mit einer ersten Fläche (10a) einer {111}—Flächensymmetrie eines kubischen Gitters zu bilden, gefertigt wird, daß das ersten Substrat (10) gehärtet wird, daß ein zweites härtbares Harz gegen die erste Fläche (10a) des gehärteten ersten Substrats (10) in einem erweichten Zustand gepreßt wird, um ein zweites Substrat (11) aus dem zweiten Harz mit einer zweiten Fläche (11a) von gleicher Ausgestaltung wie die Einkristall-Spaltebene zu fertigen, daß das zweite Substrat (11) gehärtet wird, daß ein drittes Material in einem erweichten Zustand gegen die zweite Fläche (11a) des gehärteten zweiten Substrats (11) gepreßt wird, um ein drittes Substrat (12) aus dem dritten Material mit einer dritten Fläche einer {111}—Flächensymmetrie eines kubischen Gitters als ein Nachbildungsmuster der zweiten Fläche zu fertigen, und daß das dritte Substrat (12) gehärtet wird.

4. Verfahren zur Ausbildung eines Substrats zur Verwendung bei der Herstellung von einkristallinen Dünnschichtfilmen, dadurch gekennzeichnet, daß ein in einem Verfahren nach Anspruch 1, 2 oder 3 gefertigtes Substrat (14) an der Außenoberfläche einer zylindrischen Trommel (13) befestigt wird, daß ein Material (16) in einem erweichten Zustand zwischen die zylindrische Trommel (13) und eine Hilfstrommel (15), wenn diese drehen, eingebracht wird, so daß das Nachbildungsmodell vom Substrat (14) auf die Oberfläche des Materials (16) übertragen wird, und daß anschließend das Material (16) zur Verwendung als Substrat gehärtet wird.

5. Verwendung eines nach einem der vorhergehenden Ansprüche gefertigten Substrats bei der Herstellung von einkristallinen Dünnschichten.

## Revendications

1. Procédé pour préparer un substrat utilisé dans la fabrication de films minces monocristallins, dans lequel on presse un matériau ramolli contre un plan de clivage (1) d'un monocristal comportant une multiplicité de saillies pyramidales quadrangulaires ayant un sommet pointu, chaque face de ces saillies ayant la symétrie d'un plan (111) d'un réseau cubique et on durcit ensuite le matériau pour former un substrat en tant que modèle réplique (2) du plan de clivage du monocristal, comportant les évidements pyramidaux inversés correspondant à ces projections.

2. Procédé selon la revendication 1, dans lequel ce substrat est préparé en tant que modèle réplique du plan de clivage du monocristal, en déposant en phase vapeur un métal sur un plan de clivage d'un monocristal (3) comportant une multiplicité de saillies pyramidales quadrangulaires ayant un sommet pointu, chaque face de ces saillies présentant la symétrie d'un plan (111) d'un réseau cubique, pour former une couche métallique (4) sur ce plan, en plaquant cette couche métallique (4) pour former une couche plaquée (5) en tant que modèle réplique du plan de clivage du monocristal sur cette couche métallique (4) et en enlevant cette couche métallique intermédiaire (4).

3. Procédé selon la revendication 1, dans lequel le substrat est préparé en pressant une première résine thermodurcissable ramollie contre un plan de clivage d'un monocristal (9) comportant une multiplicité de saillies pyramidales quadrangulaires ayant un sommet pointu, chaque face de ces saillies présentant la symétrie d'un plan (111) d'un réseau cubique pour former un premier substrat (10) de la première résine ayant, en tant que modèle réplique du plan de clivage du monocristal (9), une première surface (10a) présentant la symétrie d'un plan (111) d'un réseau cubique, en durcissant ce premier substrat (10), en pressant une deuxième résine thermodurcissable ramollie contre cette première surface (10a) du premier substrat durci (10) pour former un deuxième substrat (11) de cette deuxième résine ayant une deuxième surface (11a) ayant la même configuration que le plan de clivage du monocristal, en durcissant ce deuxième substrat (11), en pressant un troisième matériau ramolli contre la deuxième surface (11a) de ce deuxième substrat durci (11) pour former un troisième substrat (12) de ce troisième matériau présentant, en tant que modèle réplique de la deuxième surface, une troisième surface présentant la symétrie d'un plan (111) d'un réseau cubique, et un durcissant ce troisième substrat (12).

4. Procédé pour former un substrat utilisé dans la fabrication de films minces monocristallins, dans lequel un substrat (14), prépare par un procédé selon l'une des revendications 1, 2 ou 3, est fixé sur la surface extérieure d'un tambour cylindrique (13), un matériau (16) ramolli est introduit entre le tambour cylindrique (13) et un tambour auxiliaire (15) lors de leur rotation, d'où il résulte que le modèle réplique est transféré du substrat (14) sur la surface du matériau (16), et dans lequel on durcit ce matériau (16) pour l'utiliser comme substrat.

5. Utilisation d'un substrat préparé selon l'une quelconque des revendications précédentes dans la fabrication de films minces monocristallins.

*Fig. 1*

(111) plane

1

*Fig. 2*

*Fig. 3*

(111) plane

0 113 954

# Fig. 4

(1)

(2)

(3)

(4)

# Fig. 5

(1)

10
10a
9

(2)

11
10a
11a
10

(3)

12
11a
11

(4)

12

Fig. 6